# FASCICULE DE BREVET EUROPEEN

(11) **EP 4 127 741 B1**
(45) Date de publication et mention de la délivrance du brevet: **07.05.2025**
(21) Numéro de dépôt: 21716483.9
(22) Date de dépôt: 08.03.2021
(51) Int. Cl.: G01R 29/12, H03B 5/00

(54) **DETECTEUR DE CHAMP ELECTRIQUE**
DETEKTOR FÜR ELEKTRISCHE FELDER
ELECTRIC FIELD DETECTOR

(30) Priorité: 26.03.2020 FR 2003001
(43) Date de publication de la demande: 08.02.2023
(73) Titulaire: Office National d'Etudes et de Recherches Aérospatiales, 91120 Palaiseau (FR)
(72) Inventeur: LEVY, Raphael, 92240 MALAKOFF (FR); PERRIER, Thomas, 75015 PARIS (FR); LAVENUS, Pierre, 92290 CHATENAY MALABRY (FR); GUERARD, Jean, 91260 JUVISY-SUR-ORGE (FR); GAUDINEAU, Vincent, 91120 PALAISEAU (FR)
(74) Mandataire: Hautier IP
(86) Numéro de dépôt international: PCT/FR2021/050388
(87) Numéro de publication internationale: WO 2021/191520

(56) Documents cités:
- EP-A2- 0 137 148
- US-A- 4 720 682
- US-A- 6 014 028
- US-A1- 2003 038 638

## Description

### Domaine technique

La présente description concerne un détecteur de champ électrique.

### Technique antérieure

Des détecteurs de champ électrique sont connus, qui comportent au moins une électrode et un masque mobile. Le masque mobile est en un matériau conducteur électrique, et disposé devant l'électrode ou les électrodes de façon à l'occulter ou les occulter partiellement par rapport au champ électrique à mesurer. Une (des) partie(s) variable(s) de cette (ces) électrode(s) est (sont) ainsi exposée(s) au champ électrique à mesurer, générant un (des) courant(s) électrique(s) dans une (des) connexion(s) qui relie(nt) l'(chaque) électrode à un détecteur de courant. Le(s) courant(s) électrique(s) qui est (sont) détecté(s) constitue(nt) une mesure du champ électrique. Mais de tels détecteurs sont encombrants, onéreux et consommateurs d'énergie, si bien qu'ils ne sont pas adaptés pour de nombreuses applications, notamment des applications de mesure de champ électrostatique à bord d'un avion, d'un drone ou d'un satellite.

Pour remédier à ces inconvénients, des détecteurs de champ électrique ont été développés récemment à base de dispositifs MEMS, pour «Micro Electro-Mechanical Systems» en anglais, ou microsystèmes électromécaniques, en silicium. Mais la mise en œuvre d'un champ électrique pour faire vibrer le dispositif MEMS pendant chaque mesure provoque des biais dans les résultats de mesure. En outre, la mesure procède par une évaluation d'une quantité de charges électriques, nécessitant d'utiliser un convertisseur analogique-numérique à résolution élevée. Un tel convertisseur est alors lui-même onéreux et responsable d'une consommation d'énergie qui est importante.

Le document US 6,014,028 décrit plusieurs dispositifs de mesure du potentiel électrique de surface d'un objet, dans lesquels le résultat de la mesure est déduit de l'amplitude d'une composante de tension dont la fréquence est fixée.

### Problème technique

A partir de cette situation, un but de la présente invention est de proposer un nouveau détecteur de champ électrique qui soit peu encombrant, peu onéreux, dont la consommation énergétique soit faible et dont les résultats de mesure soient exacts et fiables.

### Résumé de l'invention

Pour atteindre au moins partiellement ce but ou un autre, un premier aspect de l'invention propose un détecteur de champ électrique qui comprend :
- un oscillateur électromécanique, dont une partie au moins est constituée par un élément piézoélectrique destiné à vibrer à une fréquence d'oscillation lors d'une utilisation du détecteur ;
- un dispositif de mesure de fréquence, qui est couplé à l'oscillateur de façon à mesurer la fréquence d'oscillation ; et
- un ensemble de masquage électrique, qui est disposé à proximité de l'élément piézoélectrique sans contact avec cet élément, de sorte que, lors de l'utilisation du détecteur, l'élément piézoélectrique se déplace en vibrant par rapport à l'ensemble de masquage électrique.

Selon l'invention, l'ensemble de masquage électrique est disposé en outre de sorte qu'une partie de l'élément piézoélectrique qui est exposée au champ électrique à mesurer pendant l'utilisation du détecteur, en étant limitée par cet ensemble de masquage électrique, varie au cours de chaque oscillation de l'oscillateur. Le champ électrique à mesurer qui agit sur la partie exposée et variable de l'élément piézoélectrique lors de l'utilisation du détecteur, produit une modification de la fréquence d'oscillation qui est mesurée par le dispositif de mesure de fréquence. La fréquence d'oscillation forme ainsi le résultat de mesure de l'intensité du champ électrique.

L'invention résout donc les inconvénients des détecteurs de l'art antérieur en utilisant un oscillateur piézoélectrique. De tels oscillateurs sont en effet peu onéreux, légers et de dimensions réduites. De plus, leur utilisation ne nécessite pas de générer des champs électriques susceptibles de produire un biais dans les résultats de mesure.

De façon générale pour l'invention, le matériau de l'élément piézoélectrique peut avoir des compositions chimiques variables. En particulier, cet élément piézoélectrique peut être une portion de quartz cristallin, une portion de nitrure d'aluminium (AIN), une portion de phosphate de gallium (GaPO₄), ou une portion de cristal langatate, couramment désigné par l'acronyme LGT et correspondant à la formule chimique La₃Ga_{5,5}Ta_{0,5}O₁₄, dans laquelle La désigne l'élément lanthane, Ga désigne l'élément gallium, Ta désigne l'élément tantale et O désigne l'élément oxygène. De tels matériaux cristallins sont disponibles sous forme de tranches fines, ou «wafers» en anglais, qui peuvent être gravées chimiquement afin d'obtenir l'élément piézoélectrique avec la forme qui est voulue pour cet élément.

De façon générale encore, l'élément piézoélectrique peut avoir des formes variables, adaptées pour produire les vibrations nécessaires au fonctionnement de l'oscillateur. Ainsi, dans divers modes de réalisation possibles de l'invention, l'élément piézoélectrique peut comprendre l'une des structures suivantes :
- une poutre destinée à vibrer par flexion lors de l'utilisation du détecteur, notamment une poutre qui possède une première extrémité fixe et une autre extrémité libre, opposée à la première extrémité ;
- deux poutres parallèles et destinées chacune à vibrer par flexion lors de l'utilisation du détecteur, les deux poutres étant connectées entre elles par une première extrémité respective de chacune d'elles, avec une autre extrémité de chaque poutre, opposée à sa première extrémité, qui est libre ; ou
- deux poutres parallèles et destinées chacune à vibrer par flexion lors de l'utilisation du détecteur, les deux poutres étant connectées entre elles d'une part par deux premières extrémités respectives de ces poutres, et d'autre part par leurs autres extrémités qui sont opposées aux premières extrémités.

L'ensemble de masquage électrique peut comprendre au moins une portion métallique, avec un bord de cette portion métallique qui est disposé devant l'élément piézoélectrique, de façon à l'occulter partiellement vis-à-vis du champ électrique à mesurer à au moins un instant pendant chaque oscillation. Mais de façon préférée, cet ensemble de masquage électrique peut comprendre deux portions métalliques, qui produisent des occultations partielles identiques de l'élément piézoélectrique par rapport au champ électrique à mesurer, symétriquement sur deux côtés opposés de l'élément piézoélectrique, lorsque le détecteur est orienté de sorte que les deux portions métalliques soient perpendiculaires au champ électrique à mesurer.

De façon générale, l'oscillateur électromécanique peut comprendre, en plus de l'élément piézoélectrique, au moins un amplificateur électronique qui est relié électriquement à des électrodes en contact avec l'élément piézoélectrique, de façon à constituer une structure en boucle d'oscillateur à compensation de pertes. Dans un tel cas, l'une des électrodes peut être connectée électriquement à une sortie de l'amplificateur, pour transmettre une tension électrique d'excitation à l'élément piézoélectrique pendant l'utilisation du détecteur, et une autre des électrodes peut être connectée à une entrée d'un système de détection de courant électrique, pour détecter un courant électrique de réponse qui provient de l'élément piézoélectrique. Une sortie du système de détection de courant électrique est alors connectée à une entrée de l'amplificateur, pour constituer la structure en boucle.

Avantageusement, l'une des électrodes, et de préférence chaque électrode, peut être située sur l'élément piézoélectrique à un endroit de celui-ci qui est occulté par l'ensemble de masquage électrique par rapport au champ électrique à mesurer, lors de l'utilisation du détecteur. Un biais de mesure que pourrait provoquer chaque électrode peut ainsi être réduit ou supprimé.

Enfin, un second aspect de l'invention propose un ensemble de détection de champ électrique, qui comprend deux détecteurs chacun conforme au premier aspect. Ces deux détecteurs ont des éléments piézoélectriques qui sont identiques, et des ensembles de masquage électrique respectifs qui sont différents. Ainsi, le champ électrique à mesurer, lorsqu'il est non-nul, produit des modifications de fréquence d'oscillation qui sont différentes entre les deux détecteurs. L'ensemble de détection comprend en outre une unité de soustraction, qui est agencée pour caractériser une différence entre les fréquences d'oscillation qui sont mesurées par les dispositifs de mesure de fréquence respectifs des deux détecteurs. Cette différence forme alors un autre résultat de mesure de l'intensité du champ électrique, qui est moins sensible par rapport à des variations d'une température ambiante que les résultats de mesure tels que délivrés séparément par chacun des deux détecteurs. En effet, les éléments piézoélectriques des deux détecteurs étant identiques, une variation de la température ambiante produit des décalages de fréquence d'oscillation qui sont identiques pour les deux détecteurs en l'absence de champ électrique à mesurer. Mais lorsque le champ électrique à mesurer est non-nul, il crée des modifications de fréquence d'oscillation qui sont différentes entre les deux détecteurs, du fait de leurs ensembles de masquage électrique respectifs qui sont différents. L'unité de soustraction permet alors de supprimer une contribution de la variation de température ambiante dans le résultat de mesure du champ électrique.

### Brève description des figures

Les caractéristiques et avantages de la présente invention apparaîtront plus clairement dans la description détaillée ci-après d'exemples de réalisation non-limitatifs, en référence aux figures annexées parmi lesquelles :
[Fig. 1] est un schéma de principe d'un détecteur de champ électrique qui est conforme à l'invention ;
[Fig. 2a] est une vue en perspective d'un élément piézoélectrique qui peut être utilisé dans le détecteur de [Fig. 1] ;
[Fig. 2b] est une vue de face de l'élément piézoélectrique de [Fig. 2a], montrant des électrodes disposées sur cet élément ;
[Fig. 2c] est une vue en coupe transversale qui correspond à [Fig. 2b] ;
[Fig. 2d] correspond à [Fig. 2b] pour une variante de réalisation ;
[Fig. 2e] est une vue en coupe transversale qui correspond à [Fig. 2d] ;
[Fig. 3] est une vue en perspective d'un autre élément piézoélectrique qui peut être utilisé alternativement dans le détecteur de [Fig. 1] ;
[Fig. 4] est une vue en coupe transversale qui illustre le principe de fonctionnement du détecteur de [Fig. 1] ;
[Fig. 5] est un schéma de principe d'un ensemble de détection de champ électrique qui est conforme à l'invention ;
[Fig. 6a] montre une première variante possible pour l'ensemble de détection de [Fig. 5] ; et
[Fig. 6b] montre une seconde variante possible pour l'ensemble de détection de [Fig. 5].

### Description détaillée de l'invention

Pour raison de clarté, les dimensions des éléments qui sont représentés dans ces figures ne correspondent ni à des dimensions réelles, ni à des rapports de dimensions réels. En outre, certains de ces éléments ne sont représentés que symboliquement, et des références identiques qui sont indiquées dans des figures différentes désignent des éléments identiques ou qui ont des fonctions identiques.

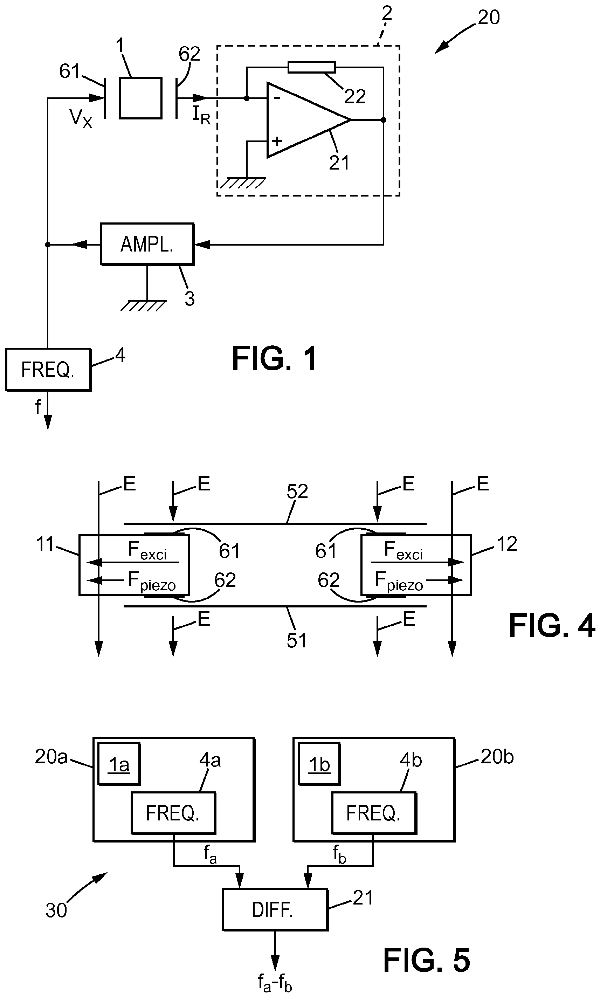

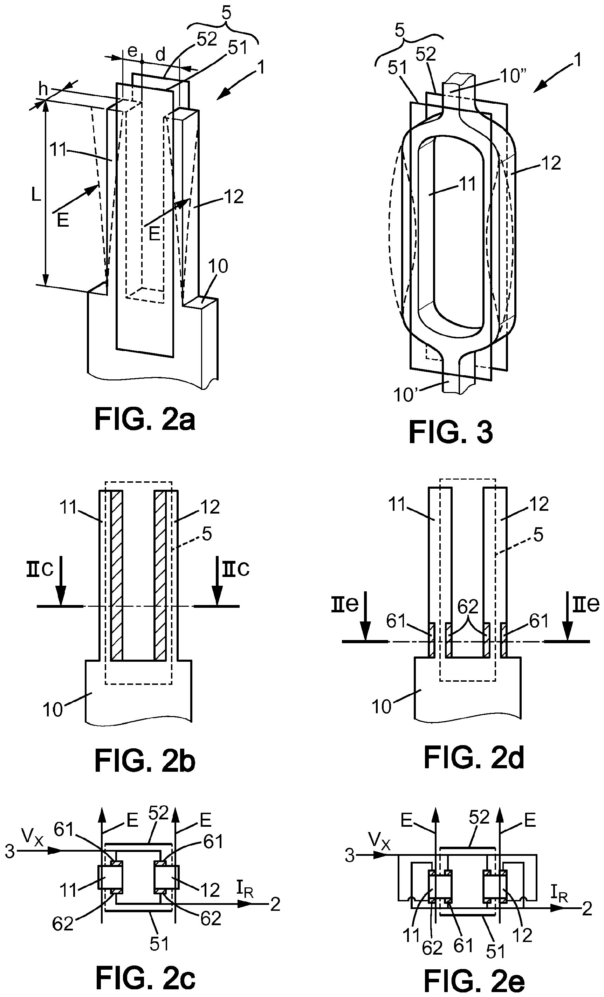

Conformément à [Fig. 1], un détecteur 20 qui est conforme à l'invention comprend un oscillateur électromécanique, un dispositif de mesure de fréquence et un ensemble de masquage électrique. L'ensemble de masquage électrique, qui n'est pas visible sur [Fig. 1], sera décrit en référence à [Fig. 2a]. L'oscillateur électromécanique comprend un élément piézoélectrique 1 qui est pourvu d'une paire d'électrodes 61 et 62, pour appliquer à l'élément 1 une tension électrique d'excitation V_{X}, et pour recueillir un signal de réponse qui est produit par cet élément 1, par exemple un courant électrique de réponse I_{R}. De façon connue, l'oscillateur est constitué par une structure en boucle qui comprend, outre l'élément piézoélectrique 1, un système de détection du courant de réponse I_{R}, désigné par la référence 2, et un amplificateur, noté AMPL. et désigné par la référence 3. Le système de détection de courant 2 peut être composé à partir d'un amplificateur opérationnel 21 qui possède une entrée inverseuse, une entrée non-inverseuse, et une sortie, et d'une résistance électrique 22. L'entrée non-inverseuse de l'amplificateur opérationnel 21 est connectée à une masse électrique du détecteur 20, l'entrée inverseuse est connectée à l'électrode 62 qui délivre le courant électrique de réponse I_{R} de l'élément piézoélectrique 1, et la résistance 22 est connectée entre l'entrée inverseuse et la sortie de l'amplificateur opérationnel 21. Dans ces conditions, le système de détection de courant électrique 2 produit en sortie une tension électrique qui est proportionnelle au courant de réponse I_{R}. D'autres constitutions électriques sont possibles pour le système de détection de courant 2, et connues de l'Homme du métier. La sortie du système de détection de courant 2 est connectée à une entrée de l'amplificateur 3, et une sortie de cet amplificateur 3 fournit la tension d'excitation V_{X} qui est appliquée à l'électrode 61. Une telle structure en boucle permet de compenser les pertes énergétiques et de satisfaire la condition de phase qui est nécessaire à l'existence d'oscillations spontanées. Ces oscillations mettent en œuvre des vibrations de l'élément piézoélectrique 1, et leur fréquence est la fréquence de résonance de l'oscillateur lorsqu'il est utilisé en circuit ouvert et en régime sinusoïdal forcé. Le dispositif de mesure de fréquence est désigné par la référence 4 et noté FREQ. Il peut être connecté à la sortie de l'amplificateur 3, en parallèle avec l'électrode 61. Ce peut être un fréquencemètre électronique usuel tel que disponible commercialement.

L'élément piézoélectrique 1 peut être un diapason en quartz cristallin tel que représenté dans [Fig. 2a]. Il est ainsi composé de deux poutres 11 et 12, parallèles et distantes l'une de l'autre, qui sont connectées rigidement l'une à l'autre par une seule de leurs extrémités respectives, par l'intermédiaire d'une partie de base fixe 10. Un tel modèle de poutre est dit à une extrémité libre et une extrémité encastrée. Les profils en traits interrompus montrent des déformations par flexion des deux poutres 11 et 12. Par principe, l'extrémité de chaque poutre 11, 12 qui est connectée rigidement à la partie de base 10 correspond à un nœud de vibration de l'élément 1. La direction longitudinale des poutres 11 et 12 est parallèle à la direction cristallographique Y du quartz cristallin qui est utilisé pour former l'élément piézoélectrique 1, et le plan du diapason est perpendiculaire à la direction cristalline X. [Fig. 2a] montre en outre l'ensemble masquage électrique 5, qui est composé des deux plaquettes métalliques 51 et 52. La référence E désigne le champ électrique à mesurer, qui traverse chaque poutre 11, 12 de l'élément piézoélectrique 1 dans des parties latérales de celles-ci qui débordent des plaquettes métalliques 51 et 52. Pour une utilisation appropriée du détecteur 20, il est orienté de sorte que le champ électrique E soit sensiblement perpendiculaire aux plaquettes métalliques 51 et 52.

[Fig. 2b] et [Fig. 2c] montrent une première disposition possible pour les électrodes 61 et 62 sur l'élément piézoélectrique 1. Elles sont disposées longitudinalement sur chaque poutre 11, 12, sur toute la longueur ou presque toute la longueur des poutres, sur les faces de celles-ci qui sont coplanaires, et contre les bords des poutres qui sont les plus proches de l'axe central du diapason. L'électrode 61 possède ainsi deux segments d'électrode qui sont disposés l'un sur la poutre 11 et l'autre sur la poutre 12, sur un même côté du diapason. De façon similaire, l'électrode 62 possède aussi deux segments d'électrode qui sont disposés l'un sur la poutre 11 et l'autre sur la poutre 12, sur l'autre côté du diapason par rapport à l'électrode 61. Les électrodes 61 et 62 ainsi disposées provoquent des élongations ou des contractions des bords internes des deux poutres 11 et 12, qui sont identiques à chaque instant des vibrations. Tous les segments d'électrodes ainsi disposés sont masqués par les plaquettes métalliques 51 et 52 par rapport au champ électrique à mesurer E.

[Fig. 2d] et [Fig. 2e] montrent une seconde disposition possible pour les électrodes 61 et 62. Elles sont limitées maintenant à une partie de chaque poutre 11, 12 qui est proche de la partie base 10, et chaque électrode 61, 62 comprend deux paires de segments d'électrode qui sont disposés et connectés pour générer, au pied de chaque poutre 11, 12, des champs électriques qui sont opposés entre le côté interne et le côté externe de chaque poutre, en étant encore symétriques entre les deux poutres 11 et 12. Un tel mode d'excitation piézoélectrique du diapason provoque une articulation de chaque poutre 11, 12 par rapport à la partie de base 10, puis chaque poutre vibre par flexion à partir de cette articulation.

[Fig. 3] montre un autre modèle possible pour l'élément piézoélectrique 1. Il est encore constitué de deux poutres 11 et 12, identiques et parallèles, mais celles-ci sont maintenant connectées l'une à l'autre par leurs deux extrémités respectives, et connectées à deux parties de base fixes 10' et 10". Un tel modèle d'élément piézoélectrique est dit articulé-articulé dans le jargon de l'Homme du métier. Chacune des poutres 11, 12 vibre encore par flexion parallèlement au plan de l'élément piézoélectrique 1, avec des sens instantanés de flexion qui sont opposés entre les deux poutres, et des valeurs instantanées de flèche qui sont identiques en valeurs absolues entre les deux poutres. Pour cet autre modèle d'élément piézoélectrique 1, les électrodes 61 et 62 peuvent avoir une configuration sur les deux poutres 11 et 12 qui est similaire à celle de [Fig. 2b] et [Fig. 2c], tout en étant limitées à une partie centrale dans la longueur des poutres.

D'autres modèles sont encore possibles pour l'élément piézoélectrique 1, notamment des modèles à une seule poutre vibrante, dont une extrémité est libre et l'autre extrémité, dite encastrée, est connectée rigidement à une partie de base fixe de l'élément. De façon connue, des éléments piézoélectriques tels que ceux qui viennent d'être décrits peuvent être fabriqués par gravure chimique ou gravure ionique réactive à partir d'une plaquette de quartz cristallin.

Conformément à [Fig. 4], l'élément piézoélectrique 1, par exemple celui de [Fig. 2a]-[Fig. 2c], est inséré entre deux masques électriques 51 et 52, qui sont disposés parallèlement l'un à l'autre sur les deux côtés opposés de l'élément 1, sans contact avec lui. Les deux masques électriques 51 et 52 constituent l'ensemble de masquage électrique 5. Ils sont symétriques pour occulter une partie de l'élément piézoélectrique 1 par rapport au champ électrique extérieur E. Celui-ci est perpendiculaire aux deux masques 51 et 52 lors d'une utilisation optimale du détecteur 20. Autrement dit, les deux plaquettes métalliques 51 et 52 sont superposées dans un plan commun de projection qui est parallèle à elles. En outre, les deux plaquettes métalliques 51 et 52 sont dimensionnées pour occulter une partie limitée de l'élément piézoélectrique 1, qui varie au cours de chaque vibration. Pour les modèles de l'élément piézoélectrique 1 de [Fig. 2a] et [Fig. 3], les deux plaquettes métalliques 51 et 52 peuvent occulter une partie respective de chaque poutre 11, 12 qui est située vers le centre de l'élément, avec des bords de ces plaquettes qui sont parallèles et superposés à une zone centrale longitudinale de chaque poutre, comme cela apparaît sur les figures. De cette façon, une partie longitudinale de chaque poutre 11, 12, qui est voisine de son bord externe, c'est-à-dire voisine de celle de ses faces qui est tournée à l'opposé de l'autre poutre, est exclusivement exposée au champ électrique E. En outre, cette partie exposée possède un volume qui varie en fonction de l'état instantané de vibration de la poutre. Dans des réalisations possibles pour chaque plaquette métallique 51, 52, celle-ci peut être constituée par une portion de couche métallique, par exemple en argent (Ag) ou en or (Au), qui a été déposée sur un substrat plan tel qu'une plaquette de verre. Les deux plaquettes métalliques 51 et 52 sont connectées électriquement l'une à l'autre, et peuvent être laissées à un potentiel électrique flottant ou bien être connectées à une borne de référence de potentiel électrique. Dans des modes de réalisation simplifiés de l'invention, l'ensemble de masque électrique 5 peut ne comprendre qu'une seule plaquette métallique, sur un seul des côtés de l'élément piézoélectrique 1.

On décrit maintenant le principe de fonctionnement du détecteur 20, en référence à [Fig. 4]. La tension électrique d'excitation V_{X} produit, au sein de l'élément piézoélectrique 1, une répartition de contraintes qui provoque la vibration de l'élément 1. En l'absence de champ électrique externe, l'oscillation spontanée de l'oscillateur électromécanique possède une valeur de fréquence f₀, qui est sa fréquence propre d'oscillation. Cette valeur f₀ dépend principalement des dimensions de l'élément piézoélectrique 1, de paramètres intrinsèques, des valeurs des constantes d'élasticité du matériau piézoélectrique, et de paramètres électriques de l'oscillateur complet. Le fonctionnement d'un tel oscillateur à sa valeur f₀ de fréquence propre d'oscillation est connu de l'Homme du métier. En particulier, au cours des oscillations à cette valeur f₀ de fréquence propre, la tension électrique d'excitation V_{X} est en quadrature de phase par rapport à la déformation de l'élément piézoélectrique 1. En effet, la tension électrique d'excitation V_{X} compense alors exactement les pertes dissipatives, telles que des pertes par frottement visqueux de l'élément piézoélectrique 1 dans un gaz environnant. Or de telles pertes sont proportionnelles à la vitesse instantanée de déformation de l'élément piézoélectrique 1. Plus précisément, la tension électrique d'excitation V_{X} génère dans chaque poutre 11, 12 une force d'excitation piézoélectrique qui est notée F_{exci}, et qui entretient les vibrations de l'élément 1 selon un régime permanent d'oscillation. La valeur f₀ de fréquence d'oscillation propre, en l'absence de champ électrique externe, peut être mesurée expérimentalement par le dispositif de mesure de fréquence 4.

Le champ électrique externe qui est noté E est le champ électrique à mesurer. Lorsqu'il n'est pas nul, il traverse l'élément piézoélectrique 1 dans la partie de celui-ci qui n'est pas occultée par l'ensemble de masquage électrique 5. Dans cette partie non-occultée, c'est-à-dire qui est exposée au champ électrique E, et qui peut être divisée entre les deux poutres 11 et 12 comme dans les exemples des figures, le champ électrique E provoque une force piézoélectrique supplémentaire, notée F_{piezo}, qui est proportionnelle à la fraction instantanée de l'élément piézoélectrique 1 qui est traversée par le champ électrique E. Cette force supplémentaire F_{piezo} est ainsi proportionnelle à la déformation instantanée de l'élément piézoélectrique 1.

En présence du champ électrique E à mesurer, la force d'excitation piézoélectrique F_{exci} qui est générée par la tension électrique d'excitation V_{X} dans l'élément 1, est très supérieure à la force piézoélectrique supplémentaire F_{piezo}. Pour cette raison, la valeur du déphasage entre la force d'excitation piézoélectrique F_{exci} et la déformation de l'élément piézoélectrique 1 n'est pas modifiée significativement. Il en résulte que les deux forces F_{piezo} et F_{exci} sont en quadrature de phase l'une par rapport à l'autre. Grâce à cette relation de quadrature de phase, la modification de valeur que provoque la force piézoélectrique supplémentaire F_{piezo} sur la fréquence d'oscillation de l'oscillateur en présence du champ électrique E est maximale, lorsque tous les autres paramètres de l'oscillateur restent inchangés. Alors : Δf= (F_{piezo}/F_{exci})·f₀/(2·Q), où Δf est la variation de fréquence d'oscillation qui provoquée par le champ électrique E, et Q est le facteur de qualité de l'élément piézoélectrique 1 lorsqu'il est utilisé comme résonateur en boucle ouverte et en régime sinusoïdal forcé. La variation Δf est égale à la différence f - f₀, où f est la fréquence d'oscillation telle que mesurée par le dispositif 4 en présence du champ électrique E. La variation de fréquence d'oscillation Δf est proportionnelle au champ électrique E : Δf = K·E, le coefficient de proportionnalité K dépendant notamment des caractéristiques géométriques et électromécaniques de l'élément piézoélectrique 1, et des caractéristiques géométriques de l'ensemble de masquage 5. Il peut être déterminé par modélisation numérique de l'oscillateur électromécanique, ou par étalonnage du détecteur 20. Pour un élément piézoélectrique 1 qui est en quartz monocristallin et conforme à [Fig. 2a], K est égal à environ 4 µHz/(V/m) (microhertz par volt-par-mètre) lorsque les deux poutres 11 et 12 ont chacune une longueur L égale à 3 mm (millimètre), une largeur e dans le plan du diapason égale à 200 µm (micromètre) et une épaisseur h mesurée perpendiculairement au plan du diapason égale à 30 µm, et que les deux poutres 11 et 12 sont espacées de la distance d égale à 100 µm. La valeur de fréquence d'oscillation f telle que délivrée par le dispositif 4 constitue donc une mesure du champ électrique E : E = (f - f₀)/K.

Toutefois, la fréquence d'oscillation propre f₀, qui est mesurée par le dispositif 4 lorsque le champ électrique E est nul, peut varier en fonction de la température de l'élément piézoélectrique 1, c'est-à-dire de la température ambiante à laquelle le détecteur 20 est utilisé. Le détecteur 20 tel que décrit précédemment ne permet pas de séparer au sein de la modification de fréquence d'oscillation f, la contribution de la variation de la fréquence d'oscillation propre f₀ qui est due à une variation de température ambiante, de la contribution qui est produite par le champ électrique à mesurer E. L'ensemble de détection qui est décrit maintenant en référence à [Fig. 5] permet de s'affranchir de la contribution thermique qui affecte la fréquence d'oscillation propre f₀, afin que le résultat de mesure qui est délivré par un tel ensemble de détection caractérise uniquement le champ électrique à mesurer, et que ce résultat soit le même, ou substantiellement le même, quelle que soit la température ambiante. Un tel perfectionnement peut être particulièrement utile lorsque la température ambiante est susceptible de varier significativement, comme c'est le cas à bord d'un satellite par exemple.

Conformément à [Fig. 5], l'ensemble de détection du champ électrique E est désigné globalement par la référence 30, et comprend deux détecteurs 20a et 20b qui sont conformes chacun au détecteur 20 de [Fig. 1]. Ces deux détecteurs 20a et 20b sont identiques l'un à l'autre, hormis leurs ensembles de masquage électrique. En particulier, les deux détecteurs 20a et 20b possèdent des éléments piézoélectriques respectifs 1a et 1b qui sont identiques et orientés identiquement, pouvant être du type diapason en quartz monocristallin tel que représenté sur [Fig. 2a]. Ils possèdent ainsi la même fréquence d'oscillation propre f₀, et celle-ci varie en fonction de la température ambiante d'une même façon pour les deux détecteurs 20a et 20b. Ces deux éléments piézoélectriques 1a et 1b sont disposés de façon fixe au sein de l'ensemble de détection 30, en étant suffisamment proches pour être exposés au même champ électrique à mesurer E. Par contre, les deux détecteurs 20a et 20b ont des ensembles respectifs de masquage électrique qui sont différents, de sorte que le coefficient K tel que défini plus haut possède deux valeurs qui sont différentes : Kₐ pour le détecteur 20a et K_{b} pour le détecteur 20b. Les références 4a et 4b désignent les dispositifs respectifs de mesure de fréquence d'oscillation des détecteurs 20a et 20b. Ainsi, en présence du champ électrique à mesurer E, le dispositif 4a fournit la première valeur de fréquence d'oscillation fₐ = fₐ + Kₐ·E, et le dispositif 4b fournit la seconde valeur de fréquence d'oscillation f_{b} = f₀ + K_{b}·E. Ces deux valeurs sont transmises à une unité de soustraction 21, qui est notée DIFF. et qui calcule la valeur d'écart fₐ - f_{b} = (Kₐ - K_{b})·E. Cette valeur d'écart, qui constitue une nouvelle mesure du champ électrique E, est indépendante de la fréquence d'oscillation propre f₀ des oscillateurs respectifs des deux détecteurs 20a et 20b. Elle ne dépend donc plus de la température ambiante par l'intermédiaire de cette fréquence d'oscillation propre f₀. Une dépendance résiduelle de l'écart fₐ - f_{b} par rapport à la température ambiante peut encore se produire à travers les coefficients Kₐ et K_{b}, mais elle est inférieure aux variations séparées des fréquences d'oscillation f₀, fₐ et f_{b} en fonction de la température.

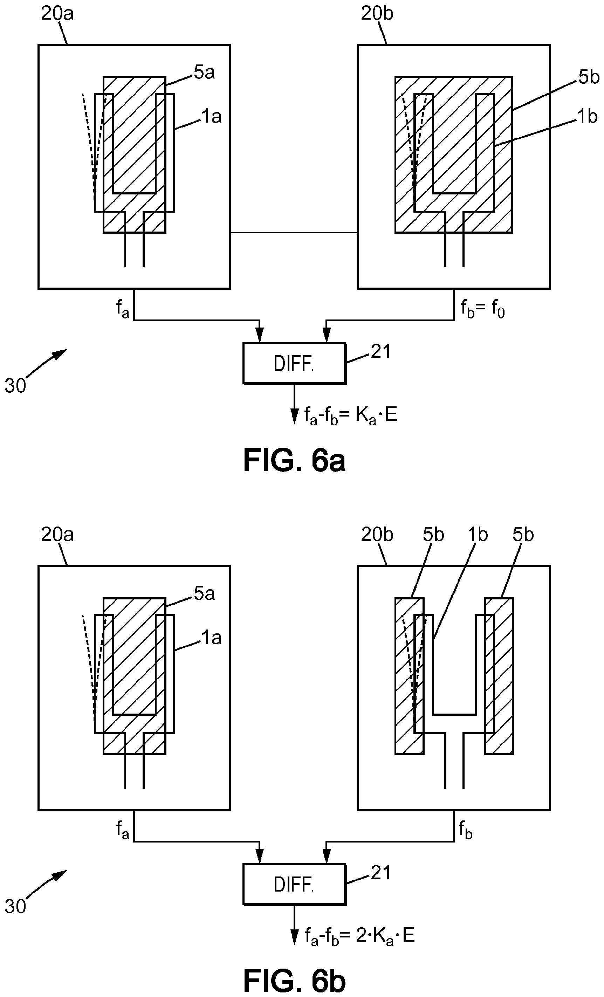

Selon une première possibilité, l'ensemble de masquage électrique du détecteur 20b, qui est désigné par la référence 5b, peut être sélectionné avec des dimensions et une position telles qu'il occulte l'élément piézoélectrique 1b de ce détecteur 20b entièrement et de façon permanente pendant les vibrations, par rapport au champ électrique E. Le détecteur 20b est ainsi insensible au champ électrique E : le coefficient K_{b} est nul et la fréquence f_{b} qui est mesurée par le dispositif 4b est constamment égale à la fréquence d'oscillation propre f₀. L'ensemble de masquage électrique du détecteur 20a, qui est désigné par la référence 5a, occulte partiellement l'élément piézoélectrique correspondant 1a, comme décrit en référence à [Fig. 2a]-[Fig. 4]. [Fig. 6a] illustre une telle configuration de l'ensemble de masquage électrique 5a (resp. 5b) par rapport à l'élément piézoélectrique 1a (resp. 1b) au sein du détecteur 20a (resp. 20b). Le résultat de mesure qui est délivré par l'unité de soustraction 21 pour le champ électrique E est alors fₐ -f₀ = Kₐ·E.

Selon une autre possibilité, l'ensemble de masquage électrique 5b du détecteur 20b peut occulter une partie limitée de l'élément piézoélectrique 1b de ce détecteur 20b, qui est complémentaire de celle qui est occultée par l'ensemble de masquage électrique 5a du détecteur 20a pour l'élément piézoélectrique 1a de ce détecteur 20a. [Fig. 6b] correspond à [Fig. 6a] pour une telle autre configuration. Dans ce cas : K_{b} = -Kₐ, et le résultat de mesure qui est délivré par l'unité de soustraction 21 pour le champ électrique E est fₐ - f_{b} = 2·Kₐ·E.

Il est entendu que l'invention peut être reproduite en modifiant des aspects secondaires des modes de réalisation qui ont été décrits en détail ci-dessus, tout en conservant certains au moins des avantages cités. Notamment, des éléments piézoélectriques qui possèdent des géométries différentes de celles montrées par [Fig. 2a] et [Fig. 3] peuvent être utilisés. En outre, des modules électroniques différents mais à fonctions équivalentes de ceux décrits peuvent être utilisés à la place de ces derniers.

## Revendications

1. Détecteur (20) de champ électrique, comprenant :
- un oscillateur électromécanique, dont une partie au moins est constituée par un élément piézoélectrique (1) destiné à vibrer à une fréquence d'oscillation lors d'une utilisation du détecteur ; et
- un ensemble de masquage électrique (5), qui est disposé à proximité de l'élément piézoélectrique (1) sans contact avec ledit élément piézoélectrique, de sorte que, lors de l'utilisation du détecteur, l'élément piézoélectrique se déplace en vibrant par rapport à l'ensemble de masquage électrique,
l'ensemble de masquage électrique (5) étant disposé en outre de sorte qu'une partie de l'élément piézoélectrique (1) qui est exposée à un champ électrique (E) à mesurer pendant l'utilisation du détecteur (20), en étant limitée par ledit ensemble de masquage électrique, varie au cours de chaque oscillation de l'oscillateur,
le détecteur étant **caractérisé en ce qu'**il comprend en outre :
- un dispositif de mesure de fréquence (4), qui est couplé à l'oscillateur de façon à mesurer la fréquence d'oscillation,
et **en ce que**, le champ électrique (E) à mesurer agissant sur la partie exposée et variable de l'élément piézoélectrique (1) lors de l'utilisation du détecteur (20), produit ainsi une modification de la fréquence (f) d'oscillation qui est mesurée par le dispositif de mesure de fréquence (4), ladite fréquence d'oscillation formant un résultat de mesure d'une intensité du champ électrique.

2. Détecteur (20) selon la revendication 1, dans lequel l'élément piézoélectrique (1) est une portion de quartz cristallin, une portion de nitrure d'aluminium, une portion de phosphate de gallium, ou une portion d'un cristal de formule chimique La₃Ga_{5,5}Ta_{0,5}O₁₄.

3. Détecteur (20) selon la revendication 1 ou 2, dans lequel l'élément piézoélectrique (1) comprend une poutre destinée à vibrer par flexion lors de l'utilisation du détecteur, notamment une poutre qui possède une première extrémité fixe et une autre extrémité libre, opposée à la première extrémité,
ou l'élément piézoélectrique comprend deux poutres (11, 12) parallèles et destinées chacune à vibrer par flexion lors de l'utilisation du détecteur (20), les deux poutres étant connectées entre elles par une première extrémité respective de chacune desdites deux poutres, avec une autre extrémité de chaque poutre, opposée à la première extrémité de la même poutre, qui est libre,
ou l'élément piézoélectrique (1) comprend deux poutres (11, 12) parallèles et destinées chacune à vibrer par flexion lors de l'utilisation du détecteur (20), les deux poutres étant connectées entre elles d'une part par deux premières extrémités respectives desdites poutres, et d'autre part par deux autres extrémités respectives desdites poutres, opposées auxdites deux premières extrémités.

4. Détecteur (20) selon l'une quelconque des revendications précédentes, dans lequel l'ensemble de masquage électrique (5) comprend au moins une portion métallique, avec un bord de ladite portion métallique qui est disposé devant l'élément piézoélectrique (1), de façon à occulter partiellement ledit élément piézoélectrique vis-à-vis du champ électrique (E) à mesurer à au moins un instant pendant chaque oscillation.

5. Détecteur (20) selon la revendication 4, dans lequel l'ensemble de masquage électrique (5) comprend deux portions métalliques (51, 52), qui produisent des occultations partielles identiques de l'élément piézoélectrique (1) par rapport au champ électrique (E) à mesurer, symétriquement sur deux côtés opposés dudit élément piézoélectrique, lorsque le détecteur est orienté de sorte que lesdites deux portions métalliques soient perpendiculaires au champ électrique à mesurer.

6. Détecteur (20) selon l'une quelconque des revendications précédentes, dans lequel l'oscillateur électromécanique comprend, en plus de l'élément piézoélectrique (1), au moins un amplificateur électronique (3) qui est relié électriquement à des électrodes (61, 62) en contact avec l'élément piézoélectrique, de façon à constituer une structure en boucle d'oscillateur à compensation de pertes.

7. Détecteur (20) selon la revendication 6, dans lequel l'une des électrodes (61, 62) est connectée électriquement à une sortie de l'amplificateur (3), pour transmettre une tension électrique d'excitation (V_{X}) à l'élément piézoélectrique (1) pendant l'utilisation du détecteur, et une autre des électrodes est connectée à une entrée d'un système (2) de détection de courant électrique, pour détecter un courant électrique de réponse (I_{R}) provenant de l'élément piézoélectrique, et une sortie du système de détection de courant électrique est connectée à une entrée de l'amplificateur.

8. Détecteur (20) selon la revendication 6 ou 7, dans lequel l'une des électrodes (61, 62), et de préférence chaque électrode, est située sur l'élément piézoélectrique (1) à un endroit dudit élément piézoélectrique qui est occulté par l'ensemble de masquage électrique (5) par rapport au champ électrique (E) à mesurer, lors de l'utilisation du détecteur.

9. Ensemble de détection de champ électrique (30), comprenant deux détecteurs (20a, 20b) chacun conforme à l'une quelconque des revendications précédentes, lesdits deux détecteurs ayant des éléments piézoélectriques (1a, 1b) respectifs qui sont identiques, et des ensembles de masquage électrique (5a, 5b) respectifs qui sont différents, de sorte que le champ électrique (E) à mesurer, lorsque ledit champ électrique à mesurer est non-nul, produise des modifications de fréquence d'oscillation (fₐ, f_{b}) qui sont différentes entre les deux détecteurs,
l'ensemble de détection (30) comprenant en outre une unité de soustraction (21), agencée pour caractériser une différence entre les fréquences d'oscillation (fₐ, f_{b}) qui sont mesurées par les dispositifs (4a, 4b) de mesure de fréquence respectifs des deux détecteurs (20a, 20b), ladite différence formant un autre résultat de mesure de l'intensité du champ électrique (E), qui est moins sensible par rapport à des variations d'une température ambiante que les résultats de mesure tels que délivrés séparément par chacun des deux détecteurs.

## Patentansprüche

1. Elektrofelddetektor (20), umfassend:
- einen elektromechanischen Oszillator, von dem mindestens ein Teil aus einem piezoelektrischen Element (1) gebildet wird, das bei Verwendung des Detektors mit einer Oszillationsfrequenz vibrieren soll; und
- eine elektrische Maskierungsbaugruppe (5), die in der Nähe des piezoelektrischen Elements (1) berührungslos mit dem piezoelektrischen Element angeordnet ist, so dass sich das piezoelektrische Element bei Verwendung des Detektors im Verhältnis zur elektrischen Maskierungsbaugruppe schwingend bewegt,
wobei die elektrische Maskierungsgruppe (5) ferner so angeordnet ist, dass ein Teil des piezoelektrischen Elements (1), der während der Verwendung des Detektors (20) einem zu messenden elektrischen Feld (E) ausgesetzt ist, durch die elektrische Maskierungsbaugruppe begrenzt wird, während jeder Schwingung des Oszillators variiert, wobei der Detektor ferner Folgendes umfasst:
- eine Frequenzmessvorrichtung (4), die mit dem Oszillator gekoppelt ist, um die Schwingungsfrequenz zu messen,
und dass das zu messende elektrische Feld (E), das bei Verwendung des Detektors (20) auf den freiliegenden und variablen Teil des piezoelektrischen Elements (1) wirkt, somit eine Änderung der Schwingungsfrequenz (f) bewirkt, die von der Frequenzmesseinrichtung (4) gemessen wird, wobei die Schwingungsfrequenz ein Messergebnis einer elektrischen Feldstärke bildet.

2. Elektrofelddetektor (20) nach Anspruch 1, wobei das piezoelektrische Element (1) ein kristalliner Quarzabschnitt, ein Aluminiumnitridabschnitt, ein Galliumphosphatabschnitt oder ein Teil eines Kristalls mit der chemischen Formel La₃Ga _{5,5}Ta _{0,5}O₁₄ ist.

3. Elektrofelddetektor (20) nach Anspruch 1 oder 2, wobei das piezoelektrische Element (1) einen Träger umfasst, der dazu bestimmt ist, bei Verwendung des Detektors durch Biegung zu vibrieren, insbesondere einen Träger, der ein erstes festes Ende und ein anderes freies Ende aufweist, das dem ersten Ende gegenüberliegt,
oder das piezoelektrische Element zwei parallele Träger (11, 12) umfasst, die jeweils dazu bestimmt sind, bei Verwendung des Detektors (20) durch Biegung zu schwingen, wobei die beiden Träger durch ein jeweiliges erstes Ende jedes dieser beiden Träger miteinander verbunden sind, mit einem anderen Ende jedes Trägers, das dem ersten Ende desselben Trägers gegenübersteht, der frei ist,
oder das piezoelektrische Element (1) zwei parallele Träger (11, 12) umfasst, die jeweils dazu bestimmt sind, bei Verwendung des Detektors (20) durch Biegung zu schwingen, wobei die beiden Träger einerseits durch jeweils zwei erste Enden der Träger miteinander verbunden sind, und andererseits durch jeweils zwei weitere Enden der Träger, die den beiden ersten Enden gegenüberliegen.

4. Elektrofelddetektor (20) nach einem der vorhergehenden Ansprüche, wobei die elektrische Maskierungsbaugruppe (5) mindestens einen Metallabschnitt umfasst, mit einem Rand des Metallabschnitts, der vor dem piezoelektrischen Element (1) angeordnet ist, so dass das piezoelektrische Element gegenüber dem zu messenden elektrischen Feld (E) bei mindestens einem Moment während jeder Schwingung teilweise verdeckt wird.

5. Elektrofelddetektor (20) nach Anspruch 4, wobei die elektrische Maskierungsbaugruppe (5) zwei Metallabschnitte (51,52) umfasst, die identische Teilverdeckungen des piezoelektrischen Elements (1) in Bezug auf das zu messende elektrische Feld (E) erzeugen, symmetrisch auf zwei gegenüberliegenden Seiten des piezoelektrischen Elements, wenn der Detektor so ausgerichtet ist, dass die beiden Metallabschnitte senkrecht zum zu messenden elektrischen Feld stehen.

6. Elektrofelddetektor (20) nach einem der vorhergehenden Ansprüche, wobei der elektromechanische Oszillator zusätzlich zum piezoelektrischen Element (1) mindestens einen elektronischen Verstärker (3) umfasst, der elektrisch mit Elektroden (61, 62) verbunden ist, die mit dem piezoelektrischen Element in Kontakt stehen, um eine verlustkompensierte Oszillatorschleifenstruktur zu bilden.

7. Elektrofelddetektor (20) nach Anspruch 6, wobei eine der Elektroden (61, 62) elektrisch mit einem Ausgang des Verstärkers (3) verbunden ist, um während der Verwendung des Detektors eine elektrische Erregerspannung (Vₓ) an das piezoelektrische Element (1) zu übertragen, und eine andere der Elektroden mit einem Eingang eines elektrischen Stromerfassungssystems (2) verbunden ist, um einen elektrischen Ansprechstrom (IR) vom piezoelektrischen Element zu erfassen, und ein Ausgang des elektrischen Stromerkennungssystems ist mit einem Verstärkereingang verbunden.

8. Elektrofelddetektor (20) nach Anspruch 6 oder 7, wobei sich eine der Elektroden (61, 62), und vorzugsweise jede Elektrode, am piezoelektrischen Element (1) an einer Stelle des piezoelektrischen Elements befindet, die durch die elektrische Maskierungsbaugruppe (5) in Bezug auf das zu messende elektrische Feld (E) bei Verwendung des Detektors verdeckt ist.

9. Elektrische Felddetektionseinheit (30), umfassend zwei Elektrofelddetektoren (20a, 20b), die jeweils einem der vorhergehenden Ansprüche entsprechen, wobei die beiden Detektoren piezoelektrische Elemente (1a, 1b) aufweisen, die identisch sind, und die jeweiligen elektrischen Maskierungsbaugruppen (5a, 5b), die unterschiedlich sind, so dass das zu messende elektrische Feld (E), wenn das zu messende elektrische Feld nicht Null ist, Veränderungen der Schwingungsfrequenz hervorruft (fₐ, f_{b}), die sich zwischen den beiden Detektoren unterscheiden,
die Detektionseinheit (30), die ferner eine Subtraktionseinheit (21) umfasst, die so angeordnet ist, dass sie einen Unterschied zwischen den Schwingungsfrequenzen (fₐ, f_{b}) charakterisiert, die von den jeweiligen Frequenzmesseinrichtungen (4a, 4b) der beiden Elektrofelddetektoren (20a, 20b) gemessen werden, wobei der Unterschied ein weiteres Messergebnis der elektrischen Feldstärke (E) bildet, das in Bezug auf Änderungen einer Umgebungstemperatur weniger empfindlich ist als die Messergebnisse, wie sie getrennt von jedem der beiden Elektrofelddetektoren ausgegeben werden.

## Claims

1. Electric field detector (20), comprising:
- an electromechanical oscillator, at least one part of which is in the form of a piezoelectric element (1) intended to vibrate at an oscillation frequency during use of the detector; and
- an electrical masking assembly (5), which is arranged in the vicinity of the piezoelectric element (1) without contacting said piezoelectric element, such that, during the use of the detector, the piezoelectric element moves by vibrating relative to the electrical masking assembly, the electrical masking assembly (5) also being arranged such that a portion of the piezoelectric element (1) that is exposed to an electrical field (E) to be measured during the use of the detector (20), being limited by said electrical masking assembly, varies during each oscillation of the oscillator, the detector being **characterised in that** it further comprises:
- a frequency measuring device (4), which is coupled to the oscillator so as to measure the oscillation frequency, and **in that** the electrical field (E) to be measured, acting on the exposed and variable portion of the piezoelectric element (1) during the use of the detector (20), thus produces a change in the oscillation frequency (f) which is measured by the frequency measuring device (4), said oscillation frequency forming a measurement result of an electric field intensity.

2. Detector (20) according to claim 1, wherein the piezoelectric element (1) is a portion of crystalline quartz, a portion of aluminium nitride, a portion of gallium phosphate or a portion of a crystal of chemical formula La₃Ga_{5.5}Ta _{0.5}O₁₄.

3. Detector (20) according to claim 1 or 2, wherein the piezoelectric element (1) comprises a beam intended to vibrate by bending during the use of the detector, in particular a beam which has a first fixed end and another free end, opposite the first end,
or the piezoelectric element comprises two parallel beams (11, 12) each intended to vibrate by bending during the use of the detector (20), both beams being connected to each other by a respective first end of each of said two beams, with another end of each beam, opposite the first end of the same beam, which is free,
or the piezoelectric element (1) comprises two parallel beams (11, 12) each intended to vibrate by bending during the use of the detector (20), both beams being connected to one another, on the one hand by two respective first ends of said beams and on the other hand by two respective other ends of said beams, opposite to said two first ends.

4. Detector (20) according to any one of the preceding claims, wherein the electrical masking assembly (5) comprises at least one metal portion, with an edge of said metal portion being arranged in front of the piezoelectric element (1), so as to partially mask said piezoelectric element with respect to the electrical field (E) to be measured, at at least one instant during each oscillation.

5. Detector (20) according to claim 4, wherein the electrical masking assembly (5) comprises two metal portions (51,52), which produce identical partial maskings of the piezoelectric element (1) with respect to the electrical field (E) to be measured, symmetrically on two opposite sides of said piezoelectric element, when the detector is oriented such that said two metal portions are perpendicular to the electrical field to be measured.

6. Detector (20) according to any one of the preceding claims, wherein the electromechanical oscillator comprises, in addition to the piezoelectric element (1), at least one electronic amplifier (3) which is electrically connected to electrodes (61, 62) in contact with the piezoelectric element, so as to form a loss-compensating oscillator loop structure.

7. Detector (20) according to claim 6, wherein one of the electrodes (61, 62) is electrically connected to an output of the amplifier (3), to transmit an electrical excitation voltage (Vₓ) to the piezoelectric element (1) during the use of the detector, and another of the electrodes is connected to an input of an electrical current detection system (2), to detect an electrical response current (IR) from the piezoelectric element, and an output of the electrical current detection system is connected to an input of the amplifier.

8. Detector (20) according to claim 6 or 7, wherein one of the electrodes (61, 62), and preferably each electrode, is located on the piezoelectric element (1) at a location of said piezoelectric element which is masked by the electrical masking assembly (5) with respect to the electrical field (E) to be measured, during the use of the detector.

9. Electric field detection assembly (30), comprising two detectors (20a, 20b) each according to any one of the preceding claims, said two detectors having respective piezoelectric elements (1a, 1b) that are identical and respective electrical masking assemblies (5a, 5b) that are different, so that the electrical field (E) to be measured, when said electric field to be measured is non-zero, produces changes in the oscillation frequency (fₐ, f_{b} ) which differ between the two detectors,
the detection assembly (30) further comprising a subtraction unit (21), arranged to characterise a difference between the oscillation frequencies (fₐ, f_{b}) measured by the respective frequency measuring devices (4a, 4b) of the two detectors (20a, 20b), said difference forming another electric field strength measurement result (E), which is less sensitive to changes in ambient temperature than the measurement results delivered separately by each of the two detectors.
